# EUROPÄISCHE PATENTSCHRIFT

(11) **EP 3 137 863 B1**
(45) Veröffentlichungstag und Bekanntmachung des Hinweises auf die Patenterteilung: **11.11.2020**
(21) Anmeldenummer: 15720325.8
(22) Anmeldetag: 29.04.2015
(51) Int. Cl.: G01J 3/51, G01J 4/04, G01J 3/02, H03M 7/30, H03M 5/00, H04N 17/00, H04N 9/04, G01J 3/28, H04N 5/225, H03M 7/00, H04N 5/00

(54) **SENSORANORDNUNG ZUM ERFASSEN ORTSAUFGELÖSTER PHOTOMETRISCHER DATEN**
SENSORARRANGEMENT FOR MEASURING SPATIALLY RESOLVED PHOTOMETRIC DATA
SYSTÈME DE DÉTECTION POUR DÉTECTER DES DONNÉES PHOTOMÉTRIQUES À RÉSOLUTION LOCALE

(30) Priorität: 30.04.2014 DE 102014208193; 23.06.2014 DE 102014211972
(43) Veröffentlichungstag der Anmeldung: 08.03.2017
(73) Patentinhaber: Zumtobel Lighting GmbH, 6850 Dornbirn (AT)
(72) Erfinder: SIEGEL, Martin, 88097 Eriskirch (DE); ZEIDLER, Gerd, A-6912 Hörbranz (AT)
(74) Vertreter: Thun, Clemens
(86) Internationale Anmeldenummer: PCT/EP2015/059359
(87) Internationale Veröffentlichungsnummer: WO 2015/165977

(56) Entgegenhaltungen:
- WO-A1-2008/014983
- WO-A1-2013/158975
- US-A1- 2013 083 312
- US-B1- 8 238 026
- RYOICHI HORISAKI ET AL: "Feasibility study for compressive multi-dimensional integral imaging", OPTICS EXPRESS, VOL. 16, NO. 7, PP. 4479-4486 (2008), Bd. 21, Nr. 4, 25. Februar 2013 (2013-02-25), Seite 4263, XP055202786, ISSN: 2161-2072, DOI: 10.1364/OE.21.004263

## Beschreibung

Die vorliegende Erfindung betrifft eine Anordnung zur Beleuchtungssteuerung, welche eine Sensoranordnung aufweist, welche dazu vorgesehen ist, ortsaufgelöste photometrische Daten, also beispielsweise Helligkeitsinformationen zu erfassen.

Helligkeitssensoren kommen in der Beleuchtungstechnologie zum Einsatz, um bspw. unabhängig von dem von außen einfallenden Tageslicht an bestimmten zu beleuchtenden Bereichen eine konstante, gleichbleibende Helligkeit zu erzielen. Dies erfolgt im Rahmen einer Regelung, indem eine den zu beleuchtenden Bereich repräsentierende Helligkeitsinformation erfasst und an eine Steuereinheit zur Steuerung der Leuchte oder Leuchten übermittelt wird. Darauf abgestimmt wird dann die Helligkeit der Leuchten modifiziert, um bspw. unabhängig von der Tageszeit jeweils eine exakt gewünschte Helligkeit zu erreichen. Sich in dem beleuchteten Bereich befindende und beispielsweise arbeitende Personen müssen dann nicht immer manuell das Kunstlicht nachregeln, was eine deutliche Verbesserung der Beleuchtungssituation mit sich bringt.

Aus dem Stand der Technik bekannt sind in erster Linie einfache Helligkeitssensoren, die auf einer einzelnen Fotodiode basieren. Diese Helligkeitssensoren sind derart ausgeführt, dass sie speziell auf einen bestimmten zu überwachenden Bereich gerichtet sind und das durch die Fotodiode, deren Helligkeitsempfinden ggf. demjenigen des menschlichen Auges angepasst ist, ausgegebene Signal dann die in dem zu überwachenden Bereich vorliegenden Helligkeit repräsentiert. Es handelt sich hierbei um verhältnismäßig einfach ausgeführte Sensoren, die kostengünstig herzustellen sind und vielfach zum Einsatz kommen.

Ein Nachteil dieser einfachen, auf einzelnen Fotodioden basierenden Helligkeitssensoren besteht allerdings darin, dass diese tatsächlich ausschließlich ein einziges, nämlich die Helligkeit repräsentierendes Signal ausgeben. Farb(ort)- oder Farbtemperaturinformationen hingegen oder andere sog. photometrische Daten können mit derartigen Sensoren nicht erhalten werden.

Des Weiteren stehen bei diesen bekannten Sensoren auch keine ortsaufgelösten Informationen zur Verfügung. D.h., soll bei einer komplexeren Beleuchtungssteuerung die Helligkeit an mehreren Orten berücksichtigt werden, so muss für jeden einzelnen zu überwachenden Ort ein separater Sensor verwendet werden.

Es wurde deshalb in der Vergangenheit auch vorgeschlagen, auf Bildsensoren basierende Sensorsysteme zu verwenden. Eine entsprechende Sensoreinheit ist bspw. in der DE 10 2010 003 804 A1 der Anmelderin beschrieben und basiert im Prinzip auf einer Digitalkamera bzw. dem Sensor einer entsprechenden Kamera, dessen Bildinformationen ausgewertet werden, um Informationen über die aktuell vorliegende Beleuchtungssituation zu erhalten. Der Vorteil derartiger intelligenter Sensoren besteht darin, dass aufgrund der zur Verfügung stehenden ortsaufgelösten Informationen die Sensoreinheit die Funktion einer Vielzahl einzelner Helligkeitssensoren übernehmen kann und darüber hinaus die Sensoren bspw. durch entsprechende Auswertung der Bilddaten zusätzlich dazu genutzt werden können, Bewegungen von Personen und damit auch deren Anwesenheit festzustellen.

Sowohl die zuvor beschriebenen einfachen Helligkeitssensoren als auch die auf Bildsensoren basierenden komplexeren Systeme sind allerdings ohne Kalibration nur eingeschränkt in der Lage, zwischen Kunstlicht und natürlichen Lichtquellen zu unterscheiden. Ferner ist bei den derzeit verfügbaren Kamerasystemen die Bestimmung des sog. Weißpunktes relativ ungenau, was auch für die daraus abgeleiteten Farb- oder Farbortinformationen gilt. Mit speziellen Filtern kann zwar die Genauigkeit der Lichtfarbmessung verbessert werden. Die Möglichkeit, die Filter auszuwechseln, ist jedoch bei vielen kommerziell erhältlichen Kamerasensoren eingeschränkt bzw. nicht möglich, da die Filter auf jeden Pixel fix vorgegeben sind.

Der vorliegenden Erfindung liegt deshalb die Aufgabenstellung zugrunde, eine Anordnung zur Beleuchtungssteuerung mit einer neuartigen Sensoranordnung zum Erfassen von ortsaufgelösten photometrischen Daten zur Verfügung zu stellen, welche zusätzlich auch in der Lage ist, Farb- bzw. Farbtemperaturinformationen zu liefern, und es erlaubt, diese Vorteile mit einem vertretbaren Aufwand zu erreichen.

Die Aufgabe wird durch eine Anordnung zur Beleuchtungssteuerung mit den Merkmalen des Anspruchs 1 gelöst. Vorteilhafte Weiterbildungen der Erfindung sind Gegenstand der abhängigen Ansprüche.

Die erfindungsgemäße Lösung beruht auf dem Gedanken, die für die Beleuchtungssteuerung genutzten ortsaufgelösten photometrischen Daten mit Hilfe einer Sensoranordnung zu erhalten, welche aus verhältnismäßig wenigen einzelnen Sensorsegmenten besteht, denen eine sog. Shutter-Anordnung vorgeordnet ist, durch welche richtungsabhängig ein Lichteinfall auf die Sensoranordnung gesteuert werden kann.

Eine derartige Anordnung zum Erfassen ortsaufgelöster Helligkeitsinformationen ist grundsätzlich bspw. aus der Veröffentlichung "Lensless Imaging by Compressive Sensing" (Gang Huang et al., Bell Labs, Alcatel-Lucent, Murray Hill, NJ 07974) bekannt. Im Vergleich zu bekannten Bildsensoren, die auf einer matrixartigen Anordnung einer Vielzahl einzelner sensitiver Elemente beruhen, kommt bei diesem neuartigen Verfahren im Prinzip lediglich ein einziges Sensorelement zum Einsatz, das allerdings gezielt richtungsabhängig über eine vor dem Sensorelement angeordnete Shutter-Matrix beleuchtet wird. Dadurch, dass mit Hilfe der Shutter-Matrix selektiv der Lichteinfall aus bestimmten Richtungen auf das Sensorelement zugelassen bzw. verhindert wird, kann im Rahmen einer späteren Auswertung der Sensorsignale und Berücksichtigung des Lichteinfalls wiederum eine ortsaufgelöste Information erhalten werden, die es letztendlich erlaubt, Bilddaten zu rekonstruieren. Vergleichbare Sensor-Konzepte sind auch aus den Dokumenten US 2013/0083312 A1, WO 2008/014983 A1, WO 2013/158975 A1, US 8,238,026 B1 sowie RYOICHI HORISAKI ET AL, "Feasibility study for compressive multi-dimensional integral imaging", OPTICS EXPRESS, VOL. 16, NO. 7, PP. 4479-4486 (2008), (20130225), vol. 21, no. 4, doi:10.1364/OE.21.004263, ISSN 2161-2072, page 4263, XP055202786 bekannt. In allen Fällen handelt es sich allerdings um Veröffentlichungen, die lediglich grundsätzlich die Realisierung derartiger Sensor zur Ermittlung von Bildinformationen beschreiben, allerdings nicht diskutieren, inwiefern das dort beschriebenen Konzept konkret zur Beleuchtungssteuerung genutzt werden können.

Da bei dieser Vorgehensweise das einzelne Sensorelement vielfach in zeitlichen Schritten nacheinander belichtet werden muss und erst am Ende einer entsprechenden Sequenz die Bilddaten rekonstruiert werden können, ist das Erstellen eines Bildes mit einem verhältnismäßig hohen Zeitaufwand verbunden. Dies ist allerdings für die Benutzung als Sensor zur Beleuchtungssteuerung akzeptabel. Dadurch, dass bei diesem Verfahren die Anzahl der Pixel deutlich reduziert wird bzw. im Prinzip nur ein einziges Sensorelement vorhanden ist, können nunmehr jedoch mit einem vertretbaren Aufwand zusätzliche Maßnahmen getroffen werden, durch welche das im Vergleich zu herkömmlichen Bildsensoren verbesserte Erhalten von Farb- bzw. Farbtemperaturinformationen bzw. allgemein von zusätzlichen photometrischen Daten ermöglicht wird. Hierzu ist erfindungsgemäß vorgesehen, dass das Sensorelement nunmehr eine Sensoreinheit mit zumindest zwei Sensorsegmenten aufweist, denen jeweils z.B. unterschiedliche Kombinationen aus Farbfiltern und/oder Polarisationsfiltern zugeordnet sind. Auf Basis der von den verschiedenen Sensorsegmenten ausgegebenen Signale werden dann die Helligkeitsinformationen durch zusätzliche photometrische Daten, also beispielsweise durch Farb- bzw. Farbtemperaturinformationen ergänzt. Weiters kann erfindungsgemäß die Verwendung eines (Licht-)Spektrometers vorgesehen sein, wodurch in der Nachverarbeitung jede beliebige Filterkurve realisiert werden kann. Die erfindungsgemäße Lösung gestattet es also, zusätzlich zur Helligkeit auch z.B. Lichtfarbe, Polarisation, spektrale Zusammensetzung und/oder andere Lichtparameter zu erfassen.

Erfindungsgemäß wird somit ein System zur Beleuchtung eines Raums vorgeschlagen, welches aufweist:
a) Leuchten,
b) eine Sensoranordnung zum Erfassen ortsaufgelöster photometrischer Daten sowie
c) eine Steuereinheit zur Helligkeitssteuerung der Leuchten auf Basis der von der Sensoranordnung ausgegebenen Informationen,
   wobei die Sensoranordnung aufweist:
   - eine Sensoreinheit mit neun matrixartig angeordneten Sensorsegmenten, denen jeweils unterschiedliche Kombinationen aus Farbfiltern, und Polarisationsfiltern zugeordnet sind,
      wobei drei verschiedene Farbfilter vorgesehen sind, die streifenartig ausgeführt sind und jeweils eine Reihe oder eine Spalte der matrixartig angeordneten Sensorsegmente bedecken, und
      wobei von den einem Farbfilter zugeordneten Sensorsegmenten einem ersten Sensorsegment kein Polarisationsfilter, einem zweiten Sensorsegment ein erstes Polarisationsfilter und einem dritten Sensorsegment ein zweites Polarisationsfilter zugeordnet sind, wobei die beiden Polarisationsfilter senkrecht zueinander orientiert sind,
   - eine der Sensoreinheit vorgeordnete, steuerbare Shutter-Anordnung, durch welche richtungsabhängig ein Lichteinfall auf die Sensoreinheit gesteuert werden kann,
      wobei die Shutter-Anordnung eine Vielzahl einzelner Elemente aufweist, welche wahlweise derart angesteuert werden können, dass sie einen Lichteinfall auf die Sensoreinheit zulassen oder nicht, so dass abhängig davon, welches Segment einen Lichteinfall ermöglicht, das Licht aus unterschiedlichen Richtungen auf die Sensoreinheit trifft, wobei der durch die Einzelelemente ermöglichte Lichteinfall die Sensoreinheit im Wesentlichen gleichmäßig beleuchtet und
      wobei die Shutter-Anordnung derart ausgebildet ist, dass die Einzelelemente zeitlich aufeinanderfolgend entsprechend einem speziellen Schema angesteuert werden, derart, dass gezielt der Einfall von Licht aus bestimmten Richtungen bzw. Winkeln auf die Sensoreinheit erfolgt, sowie
   - eine Bewertungseinheit zum Bewerten der von der Sensoreinheit ausgegebenen Informationen und Berechnen einer ortsaufgelösten Helligkeitsinformation, wobei die Bewertungseinheit dazu ausgebildet ist, auf Basis der von den verschiedenen Sensorsegmenten ausgegebenen Signale die Helligkeitsinformationen durch zusätzliche photometrische Daten zu ergänzen.

Die Erfindung kombiniert also einerseits eine neuartige Technologie, mit der trotz Verwendung im Prinzip lediglich eines einzelnen bzw. nur weniger Sensorelemente ortsaufgelöste Informationen erhalten werden können, mit dem Gedanken des Einsatzes zusätzlicher Farb- und Polarisationsfilter oder Spektrometer, durch welche die Erfassung beispielsweise von Farb- oder Farbtemperaturinformationen optimiert wird. Beide Technologien werden in vorteilhafter Weise miteinander kombiniert, da sie jeweils für sich allein genommen keine zufriedenstellenden Ergebnisse liefern würden bzw. der Einsatz von Polarisationsfiltern, speziell solche auf Pixelebene und mit unterschiedlicher Orientierung bei klassischen Bildsensoren aufgrund der damit verbundenen Kosten wirtschaftlich nicht praktikabel wäre. Es wird also eine Sensoranordnung geschaffen, welche mit einem vertretbaren Aufwand herstellbar ist, allerdings hinsichtlich der Qualität der damit erhaltenen Daten deutliche Vorteile gegenüber bislang bekannten Systemen aufweist.

Vorzugsweise weist die Sensoreinheit ein ganzzahliges Vielfaches von drei Sensorsegmenten auf, denen jeweils drei verschiedene Farbfilter in den Farben Rot, Grün und Blau zugeordnet sind. Gegenüber der in dem oben zitierten Artikel beschriebenen Vorgehensweise wird also die Sensoreinheit selbst nicht durch einen einzigen Sensor gebildet, sondern geringfügig komplexer ausgestaltet, wobei nunmehr dann den Sensoren unterschiedliche Farbfilter vorgeordnet werden, so dass im Vergleich hierzu nunmehr auch Farbinformationen erhalten werden können.

Gemäß einer besonders bevorzugten Ausführungsform weist die Sensoranordnung insgesamt neun verschiedene Sensorsegmente auf.

Ergänzend hierzu kann die Anordnung auch mit einem Spektrometer kombiniert werden, wodurch dann die Möglichkeit besteht, zusätzlich Informationen hinsichtlich der spektralen Zusammensetzung des Lichts zu erhalten. In der Nachbearbeitung der erfassten Daten können dann beliebige Filtereigenschaften realisiert werden.

Die der Sensoreinheit vorgeordnete Shutter- Anordnung kann unterschiedlich ausgestaltet sein, solange sie das richtungsabhängige Belichten der Sensoreinheit ermöglicht. Denkbar wäre bspw. die Verwendung von Mikrospiegeln, mechanischen Shuttern, sog. MEMS-Systeme oder der Einsatz eines LCD-Arrays. In allen diesen Fällen ist gewährleistet, dass entsprechend dem zuvor erwähnten Prinzip die Sensoren zeitlich nacheinander aus unterschiedlichen Richtungen belichtet werden und durch Zusammenfügen dieser Informationen dann die ortsaufgelösten Bilddaten ermittelt werden können.

Nachfolgend soll die Erfindung anhand der beiliegenden Zeichnung näher erläutert werden. Es zeigen:
Figur 1 schematisch die Verwendung einer Sensoranordnung zur erfindungsgemäßen Beleuchtungssteuerung;
Figur 2 den prinzipiellen Aufbau der Anordnung zum Erfassen ortsaufgelöster Bildinformationen und
Figur 3 die Ausgestaltung der bei der Sensoranordnung zum Einsatz kommenden Sensoreinheit.

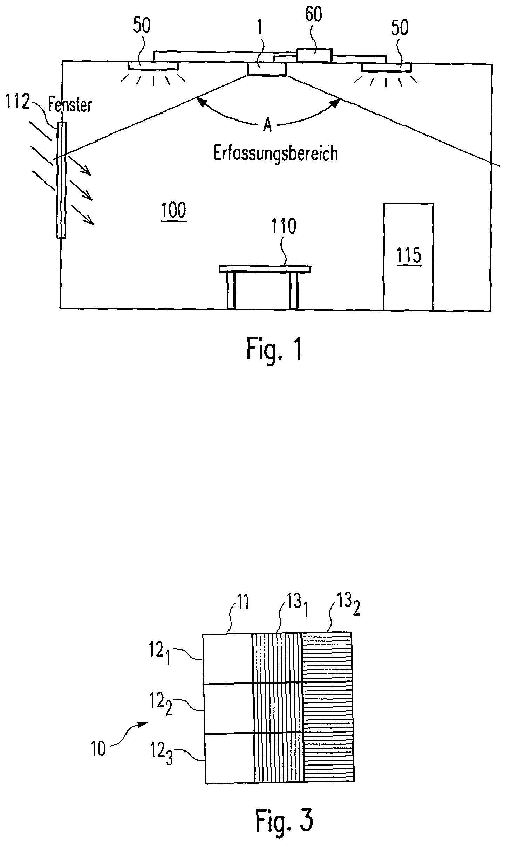

Figur 1 zeigt zunächst allgemein das Prinzip der Verwendung der Sensoranordnung, die hier mit dem Bezugszeichen 1 versehen und an der Decke eines mit dem Bezugszeichen 100 versehenen Raums angeordnet ist. Die Sensoranordnung 1 dient dazu, Helligkeitsinformationen sowie zusätzlich auch Farb- bzw. Farbtemperaturinformationen zu ermitteln, welche für die Steuerung von Leuchten 50, die zur Beleuchtung des Raums 100 genutzt werden, vorgesehen sind. Die von der Sensoranordnung 1 ausgegebenen Informationen werden dabei an eine Steuereinheit 60 weitergeleitet, welche dann darauf basierend eine Regelung der Helligkeitssteuerung für die Leuchten 50 übernimmt.

Mit dem Bezugszeichen A ist schematisch der Erfassungsbereich der Sensoranordnung 1 dargestellt. Wie erkennbar ist, ist dieser extrem groß und deckt idealerweise den gesamten Raum 100 ab. Dies stellt den entscheidenden Unterschied zu klassischen Lichtsensoren dar, die auf Nutzung einer einzelnen Fotodiode beruhen, welche speziell auf einen einzelnen zu bewertenden Bereich gerichtet ist. Die erfindungsgemäße Sensoranordnung 1 erfasst nämlich ortsaufgelöste Informationen hinsichtlich des gesamten Erfassungsbereichs, so dass dann nach entsprechender Auswertung entweder durch die Sensoranordnung 1 selbst oder durch die Steuereinheit 60 Informationen bzgl. mehrerer einzelner Bereiche erhalten werden, die dann gezielt zur Steuerung der Leuchten genutzt werden können. Dieses Prinzip ist bereits aus der oben erwähnten DE 10 2010 003 804 A1 der Anmelderin bekannt, bei der den ortsaufgelösten Bildinformationen einzelne sog. Bewertungsbereiche zugeordnet werden, die dann gezielt für die Helligkeitssteuerung ausgewertet werden. Bspw. könnten durch die ortsaufgelösten Helligkeitsinformationen Daten bzgl. der an einem Arbeitsplatz 110 vorliegenden Helligkeit sowie zeitgleich auch Informationen hinsichtlich des durch ein Fenster 112 eintretenden Tageslichts erhalten werden. Schließlich könnten die von der Sensoranordnung 1 ausgegebenen Informationen auch dazu genutzt werden, festzustellen, ob sich im Bereich der Eingangstür 115 des Raums 100 Personen befinden. D.h., ebenso wie andere bekannte, intelligente und auf Bildsensoren basierende Sensoreinheiten 1 ist auch die vorliegende erfindungsgemäße Anordnung in der Lage, multifunktional eingesetzt zu werden und eine Vielzahl von Daten zur Verfügung zu stellen, die für die Beleuchtungssteuerung benutzt werden können.

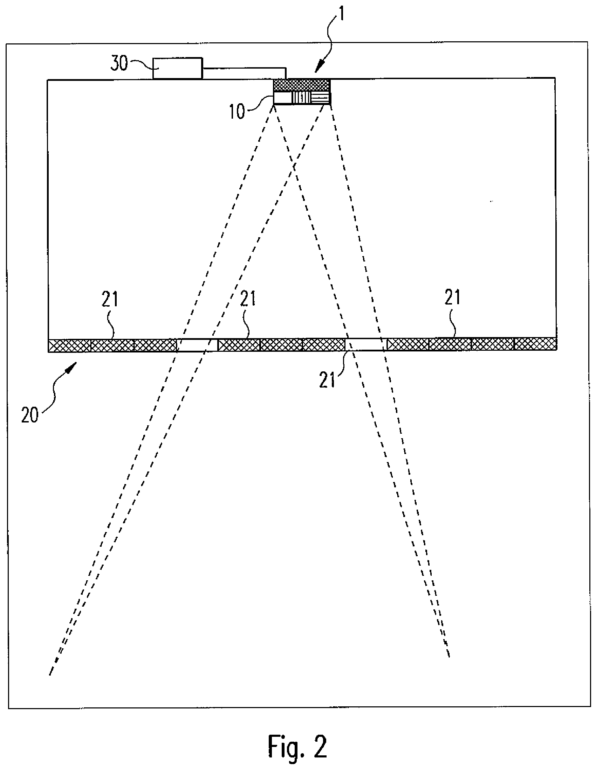

Die Besonderheit der erfindungsgemäßen Sensoranordnung 1 besteht dabei in deren Aufbau, der nachfolgend näher anhand der Figuren 2 und 3 erläutert werden soll.

Wie bereits erwähnt, war es bislang üblich, zum Realisieren intelligenter Lichtsensoren auf digitalen Bildsensoren basierende Systeme, in einfacher Weise Digitalkameras zu verwenden. Die Bildsensoren derartiger Kameras bestehen bekanntlicherweise aus einer extrem hohen Anzahl lichtempfindlicher Elemente, den sog. Pixeln, welche durch eine entsprechende Optik im Wesentlichen gleichzeitig belichtet werden und letztendlich das Bild liefern. Demgegenüber zeichnet sich die erfindungsgemäße Sensoranordnung 1 dadurch aus, dass eine extrem einfach aufgebaute Sensoreinheit mit nur wenigen einzelnen Segmenten zum Einsatz kommt und trotz allem ortsaufgelöste Informationen erhalten werden können.

Das hierzu genutzte Prinzip ist schematisch in Figur 2 erkennbar. Die Sensoreinheit 10, welche - wie nachfolgend noch näher erläutert - aus einigen wenigen, vorzugsweise aus maximal neun einzelnen Pixeln bzw. Segmenten besteht, ist hier an der Rückseite einer sog. Shutter-Anordnung 20 angeordnet. Die Shutter-Anordnung 20 weist einen gewissen Abstand zu der Sensoreinheit 10 auf und ist hinsichtlich ihrer gesamten Abmessungen deutlich größer gestaltet als die Sensoreinheit 10. Sie besteht aus einzelnen Elementen 21, welche wahlweise derart angesteuert werden können, dass sie einen Lichteinfall auf die Sensoreinheit 10 zulassen oder nicht. Genau genommen sind diese Einzelelemente 21 der Shutter- Anordnung 20 matrixartig angeordnet, so dass abhängig davon, welches Segment 21 gerade einen Lichteinfall ermöglicht, das Licht aus unterschiedlichen Richtungen auf die Sensoreinheit 10 trifft.

Zum Ermitteln ortsaufgelöster Informationen ist nunmehr vorgesehen, dass die einzelnen Elemente 21 der Shutter-Anordnung 20 zeitlich aufeinanderfolgend entsprechend einem speziellen Schema angesteuert werden, derart, dass gezielt der Einfall von Licht aus bestimmten Richtungen bzw. Winkeln auf die Sensoreinheit 10 erfolgt. Durch Zusammenführen der nacheinander erhaltenen Sensordaten kann dann eine Bewertungseinheit 30 letztendlich ein zweidimensionales Bild des von der Sensoreinrichtung 1 erfassten Bereichs ermitteln. Dies ist zwar verständlicherweise mit einem gewissen Zeitaufwand verbunden, da im Rahmen der speziellen Ansteuerung der Shutter-Anordnung 20 das Öffnen und Schließen der Einzelelemente 21 eine gewisse Zeit benötigt und das Gesamtbild erst dann erhalten werden kann, wenn alle Einzelsegmente 21 zumindest einmal geöffnet wurden. Für das Erstellen von Bildinformationen zur Beleuchtungssteuerung ist dies allerdings akzeptabel, da hier der zeitliche Aspekt eine geringere Rolle spielt. Selbst gewisse Bewegungen von Objekten innerhalb des Erfassungsbereichs während dieses Zeitraums führen zu keinen nennenswerten Verfälschungen des Messergebnisses, welches letztendlich dann für die Beleuchtungssteuerung genutzt wird.

Die Einzelelemente 21 der Shutter- Anordnung 20 können dabei in unterschiedlicher Weise gebildet und realisiert werden. Denkbar ist bspw. die Verwendung von Mikrospiegeln, mechanischen Shutter-Elementen, sog. MEMS-Elementen oder LCD-Arrays. Da für die Beleuchtungssteuerung eine verhältnismäßig grobe Ortsauflösung durchaus akzeptabel ist, kann auch die Anzahl der Einzelsegmente 21 in einem vertretbaren Rahmen gehalten werden. Die dargestellte Konfiguration mit zwölf Einzelelementen nebeneinander, die also im Falle einer quadratischen Shutter-Anordnung zu 144 Einzelelementen führt, ist durchaus realistisch.

Bei dem in dem oben zitierten Artikel beschriebenen System kommt tatsächlich nur ein einziges Sensorelement zum Einsatz, welches wahlweise durch die Shutter-Anordnung 20 richtungsabhängig belichtet wird. In diesem Fall können dann ausschließlich Helligkeitsinformationen erhalten werden, nicht jedoch zusätzliche photometrische Daten.

In Weiterbildung dieses Grundkonzepts ist deshalb gemäß der vorliegenden Erfindung vorgesehen, die Sensoreinheit 10 geringfügig komplexer zu gestalten und idealerweise, wie in Figur 3 dargestellt, durch neun matrixartig angeordnete Einzelsegmente 11 zu bilden. Diese Einzelsegmente 11 sind in einer 3x3-Matrix angeordnet, wobei die Abmessungen derart gewählt sind, dass bei Belichtung der Sensoreinheit 10 durch die Shutter-Anordnung 20 die Einzelsegmente 11 in gleicher Weise belichtet werden. D.h., wie schematisch in Figur 2 dargestellt, sind die Einzelsegmente 21 der Shutter-Anordnung 20 derart ausgeführt und die geometrischen Abmessungen derart gewählt, dass ein Einzelsegment 21 immer vollständig und gleichmäßig die Sensoreinheit 10 belichtet, so dass im Prinzip jedes Einzelsensorsegment 11 in gleicher Weise belichtet wird.

Tatsächlich liefern allerdings die einzelnen Sensorsegmente 11 unterschiedliche Messdaten, was darauf zurückzuführen ist, dass ihnen unterschiedliche Kombinationen von Farb- und Polarisationsfiltern vorgeordnet sind. Praktischerweise sind hierbei die einzelnen Filter streifenartig ausgeführt, derart, dass sie immer eine Reihe oder eine Spalte der Sensormatrix bedecken. Beispielsweise sind in den drei Reihen hintereinander drei Farbfilter 12₁, 12₂ und 12₃ angeordnet, welche bspw. als Rot-, Grün- und Blaufilter ausgeführt sind. Ferner sind senkrecht hierzu in den drei Spalten Polarisationsfilter angeordnet, wobei genau genommen nur in der mittleren und rechten Spalte Polarisationsfilter angeordnet sind und in der linken Spalte kein Polarisationsfilter vorhanden ist. Die beiden weiteren Polarisationsfilter 13₁ und 13₂ sind dabei - wie erkennbar - senkrecht zueinander orientiert.

Letztendlich führt diese Anordnung von Farb- und Polarisationsfiltern dazu, dass jedes Sensorsegment 11 mit einer bestimmten Kombination aus Farb- und Polarisationsfilter (wobei dies auch die Variante umfasst, dass kein Polarisationsfilter vorhanden ist) versehen ist. Während der Messungen liefern also die Einzelsegmente 11, welche zwar durch die Shutter-Anordnung gleichartig belichtet werden, trotzallem unterschiedliche Messsignale aufgrund der verschieden vorgeordneten Filterkombinationen.

Das Berücksichtigen dieser unterschiedlichen Messsignale durch die Bewertungseinheit der Sensoranordnung 1 führt zunächst einmal dazu, dass durch Berücksichtigung der verschiedenen Farbfilter der Farbort des Lichts, welches durch das entsprechende Element 21 der Shutter-Anordnung einfallen konnte, bestimmt werden kann. Die Berücksichtigung der unterschiedlichen Signale im Hinblick auf die Polarisationsrichtungen hingegen erlaubt Rückschluss einerseits auf die Frage, ob das einfallende Licht Kunstlicht oder natürliches Licht ist. Ferner kann im Rahmen einer entsprechenden Auswertung auch deutlich exakter die Farbtemperatur ermitteln werden. D.h., es kann nunmehr ein Weißlichtabgleich durchgeführt werden, der deutlich genauer ist, als dies bei bisherigen, auf Bildsensoren beruhenden Verfahren der Fall war. Das Zusammenführen der von den neun unterschiedlichen Sensorsegmenten ausgegebenen Signale erfolgt wie bereits erwähnt durch die interne Bewertungseinheit der Sensoranordnung, welche letztendlich insgesamt wiederum ein ortsaufgelöstes Bild erstellt, das nunmehr allerdings nicht nur Helligkeitsinformationen enthält, sondern darüber hinaus auch Farb- sowie Farbtemperaturinformationen.

Darüber hinaus wäre es wie bereits erwähnt auch denkbar, die Sensorsegmente 11 mit einem Spektrometer zu kombinieren. Dies führt zu besonderen Vorteilen, da ein Spektrometer ein verhältnismäßig teures Bauteil darstellt. Mit dem erfindungsgemäßen Prinzip könnte nunmehr ein spektraler Pixelsensor realisiert werden, der hinsichtlich der damit verbundenen Kosten deutlich günstiger herstellbar ist, als vergleichbare Lösungen, bei denen für jedes Pixel ein eigenes Spektrometer eingesetzt wird.

Ausgehend von diesem Bild kann dann eine Helligkeitssteuerung in der oben beschriebenen Weise vorgenommen werden. Wie bereits erwähnt, ist die Ortsauflösung des von der erfindungsgemäßen Sensoreinrichtung erstellten Bildes eher gering und der Zeitaufwand zum Erstellen eines Bildes ist verhältnismäßig hoch. Diese Nachteile spielen allerdings für die Beleuchtungssteuerung eine eher untergeordnete Rolle. Sie werden vielmehr deutlich von den sich ergebenen Vorteilen überwogen, dass nämlich die Helligkeitsinformationen sowie die zusätzlich erhaltenen photometrischen Daten deutlich aussagekräftiger sind, als dies bei bislang verfügbaren Systemen der Fall war. Dies ist ein für die Beleuchtungssteuerung wesentlicher Aspekt, da hierdurch sichergestellt werden kann, dass an zu beleuchtenden Bereichen tatsächlich gewünschte Verhältnisse nicht nur hinsichtlich der Helligkeit sondern auch der Farbe des Lichts vorliegen.

## Patentansprüche

1. System zur Beleuchtung eines Raums (100), aufweisend
a) Leuchten (50),
b) eine Sensoranordnung (1) zum Erfassen ortsaufgelöster photometrischer Daten sowie
c) eine Steuereinheit (60) zur Helligkeitssteuerung der Leuchten (50) auf Basis der von der Sensoranordnung (1) ausgegebenen Informationen,
wobei die Sensoranordnung (1) aufweist:
• eine Sensoreinheit (10) mit neun matrixartig angeordneten Sensorsegmenten (11), denen jeweils unterschiedliche Kombinationen aus Farbfiltern (12), und Polarisationsfiltern (13) zugeordnet sind, wobei drei verschiedene Farbfilter (12) vorhanden sind, die streifenartig ausgeführt sind und jeweils eine Reihe oder eine Spalte der matrixartig angeordneten Sensorsegmente (11) bedecken, und
wobei von den einem Farbfilter (12) zugeordneten Sensorsegmenten (11) einem ersten Sensorsegment (11) kein Polarisationsfilter, einem zweiten Sensorsegment (11) ein erstes Polarisationsfilter (13₁) und einem dritten Sensorsegment (11) ein zweites Polarisationsfilter (13₂) zugeordnet sind, wobei die beiden Polarisationsfilter (13₁, 13₂) senkrecht zueinander orientiert sind,
• eine der Sensoreinheit (10) vorgeordnete, steuerbare Shutter-Anordnung (20), durch welche richtungsabhängig ein Lichteinfall auf die Sensoreinheit (10) gesteuert werden kann,
wobei die Shutter-Anordnung (20) eine Vielzahl einzelner Elemente (21) aufweist, welche wahlweise derart angesteuert werden können, dass sie einen Lichteinfall auf die Sensoreinheit (10) zulassen oder nicht, so dass abhängig davon, welches Segment (21) einen Lichteinfall ermöglicht, das Licht aus unterschiedlichen Richtungen auf die Sensoreinheit (10) trifft, wobei der durch die Einzelelemente (21) ermöglichte Lichteinfall die Sensoreinheit (10) im Wesentlichen gleichmäßig beleuchtet und
wobei die Shutter-Anordnung (20) derart ausgebildet ist, dass die Einzelelemente (21) zeitlich aufeinanderfolgend entsprechend einem speziellen Schema angesteuert werden, derart, dass gezielt der Einfall von Licht aus bestimmten Richtungen bzw. Winkeln auf die Sensoreinheit (10) erfolgt, sowie
• eine Bewertungseinheit (30) zum Bewerten der von der Sensoreinheit (10) ausgegebenen Informationen und Berechnen einer ortsaufgelösten Helligkeitsinformation, wobei die Bewertungseinheit (30) dazu ausgebildet ist, auf Basis der von den verschiedenen Sensorsegmenten (11) ausgegebenen Signale die Helligkeitsinformationen durch zusätzliche photometrische Daten zu ergänzen.

2. System nach Anspruch 1,
**dadurch gekennzeichnet,**
**dass** die Sensoreinheit (10) zumindest 3 x n Sensorsegmente (11) aufweist, denen drei verschiedene Farbfilter (12) in den Farben rot, grün und blau zugeordnet sind.

3. System nach Anspruch 1 oder 2,
**dadurch gekennzeichnet,**
**dass** die Sensoreinheit (10) genau neun Sensorsegmente (11) aufweist.

4. System nach Anspruch 3,
**dadurch gekennzeichnet,**
**dass** die Farb- und Polarisationsfilter (12, 13) jeweils eine Reihe oder Spalte der Anordnung der Sensorsegmente (11) überdecken.

5. System nach einem der vorherigen Ansprüche,
**dadurch gekennzeichnet,**
**dass** die Einzelelemente (21) der Shutter-Anordnung durch Mikrospiegel, mechanische Shutter, Mems-Systeme oder ein LCD-Array gebildet sind.

6. System nach einem der vorherigen Ansprüche,
**dadurch gekennzeichnet,**
**dass** den Sensorelementen (11) ein Spektrometer zugeordnet ist.

## Claims

1. System for illuminating a room (100), comprising
a) luminaires (50),
b) a sensor arrangement (1) for measuring spatially resolved photometric data and
c) a control unit (60) for controlling the brightness of the luminaires (50) on the basis of the information output by the sensor arrangement (1),
wherein the sensor arrangement (1) comprises:
• a sensor unit (10) with nine sensor segments (11) which are arranged in a matrix-like fashion and to each of which different combinations of color filters (12) and polarization filters (13) are assigned,
wherein three different color filters (12) which are of strip-like design and which each cover a row or a column of the sensor segments (11) arranged in matrix-like fashion are present, and
wherein, of the sensor segments (11) assigned to a color filter (12), a first sensor segment (11) is assigned no polarization filter, a second sensor segment (11) is assigned a first polarization filter (13₁) and a third sensor segment (11) is assigned a second polarization filter (13₂), wherein the two polarization filters (13₁, 13₂) are oriented perpendicularly to each other,
• a controllable shutter arrangement (20) which is arranged upstream of the sensor unit (10) and by means of which a light incidence on the sensor unit (10) can be controlled as a function of direction,
wherein the shutter arrangement (20) has a plurality of individual elements (21), which can be selectively actuated in such a way that they allow or do not allow a light incidence onto the sensor unit (10) so that, depending on which segment (21) permits a light incidence, the light strikes the sensor unit (10) from different directions, wherein the light incidence permitted by the individual elements (21) illuminates the sensor unit (10) substantially uniformly, and
wherein the shutter arrangement (20) is designed in such a way that the individual elements (21) are actuated in chronological succession in accordance with a special scheme in such a way that the incidence of light from specific directions or angles onto the sensor unit (10) takes place selectively, and
• an evaluation unit (30) for evaluating the information output by the sensor unit (10) and calculating spatially resolved brightness information, wherein the evaluation unit (30) is designed to supplement the brightness information by additional photometric data on the basis of the signals output by the different sensor segments (11).

2. System according to Claim 1,
**characterized in that**
the sensor unit (10) has at least 3 × n sensor segments (11), to which three different color filters (12) in the colors red, green and blue are assigned.

3. System according to Claim 1 or 2,
**characterized in that**
the sensor unit (10) has precisely nine sensor segments (11).

4. System according to Claim 3,
**characterized in that**
the color and polarization filters (12, 13) each cover a row or column of the arrangement of the sensor segments (11).

5. System according to any one of the preceding claims,
**characterized in that**
the individual elements (21) of the shutter arrangement are formed by micromirrors, mechanical shutters, Mems systems or an LCD array.

6. System according to any one of the preceding claims,
**characterized in that**
a spectrometer is assigned to the sensor elements (11).

## Revendications

1. Système destiné à l'éclairage d'une pièce (100), comportant
a) des lampes (50),
b) un système de détection (1) servant à détecter des données photométriques à résolution locale, ainsi que
c) une unité de commande (60) pour la commande de la luminosité des lampes (50) sur la base des informations données par le système de détection (1),
le système de détection (1) comportant :
• une unité de détection (10) dotée de neuf segments de détection (11) disposés en matrice, auxquels sont associées respectivement différentes combinaisons de filtres colorés (12) et de filtres de polarisation (13),
trois filtres colorés (12) différents étant prévus, qui sont réalisés sous la forme de bandes et recouvrent respectivement une rangée ou une colonne des segments de détection (11) disposés en matrice et
aucun filtre de polarisation n'étant associé à un premier segment de détection (11), un premier filtre de polarisation (13₁) étant associé à un deuxième segment de détection (11) et un deuxième filtre de polarisation (13₂) étant associé à un troisième segment de détection (11) des segments de détection (11) associés à un filtre coloré (12), les deux filtres de polarisation (13₁, 13₂) étant orientés perpendiculairement l'un par rapport à l'autre,
• un système d'obturateur (20) pouvant être commandé et placé en amont de l'unité de détection (10), au moyen duquel une incidence de la lumière sur l'unité de détection (10) peut être commandée de manière directionnelle,
le système d'obturateur (20) comportant une pluralité d'éléments individuels (21), qui peuvent être commandés au choix de telle manière qu'ils autorisent ou non une incidence de la lumière sur l'unité de détection (10), de sorte que, selon le segment (21) qui permet une incidence de la lumière, la lumière atteint l'unité de détection (10) depuis différentes directions, l'incidence de la lumière permise par les éléments individuels (21) éclairant l'unité de détection (10) de manière sensiblement uniforme et
le système d'obturateur (20) étant conçu de telle manière que les éléments individuels (21) sont commandés successivement dans le temps selon un schéma spécifique, de telle sorte que l'incidence de la lumière s'effectue sur l'unité de détection (10) de manière ciblée depuis des directions ou angles défini(e)s, ainsi que
• une unité d'évaluation (30) pour évaluer les informations fournies par l'unité de détection (10) et calculer une information de luminosité à résolution locale, l'unité d'évaluation (30) étant conçue pour compléter les informations de luminosité par des données photométriques supplémentaires sur la base des signaux émis par les différents segments de détection (11).

2. Système selon la revendication 1,
**caractérisé en ce que**
l'unité de détection (10) comporte au moins 3 x n segments de détection (11), auxquels sont associés trois filtres colorés (12) différents de couleur rouge, verte et bleue.

3. Système selon la revendication 1 ou 2,
**caractérisé en ce que**
l'unité de détection (10) comporte exactement neuf segments de détection (11).

4. Système selon la revendication 3,
**caractérisé en ce que**
les filtres colorés et de polarisation (12, 13) recouvrent respectivement une rangée ou une colonne de l'ensemble des segments de détection (11).

5. Système selon l'une quelconque des revendications précédentes,
**caractérisé en ce que**
les éléments individuels (21) du système d'obturateur sont formés par des micromiroirs, des obturateurs mécaniques, des systèmes Mems ou une matrice LCD.

6. Système selon l'une quelconque des revendications précédentes,
**caractérisé en ce que**
un spectromètre est associé aux éléments de détection (11).
